# EUROPEAN PATENT SPECIFICATION

(11) **EP 4 235 244 B1**
(45) Date of publication and mention of the grant of the patent: **29.01.2025**
(21) Application number: 22305205.1
(22) Date of filing: 24.02.2022
(51) Int. Cl.: G02B 6/42, H01S 5/0239, H01L 23/367, H01S 5/024, H01L 23/38, H01L 23/42

(54) **APPARATUS FOR INTEGRATING AN ELECTRONIC INTEGRATED CIRCUIT AND A PHOTONIC INTEGRATED CIRCUIT**
VORRICHTUNG ZUR INTEGRATION EINER INTEGRIERTEN ELEKTRONISCHEN SCHALTUNG UND EINER INTEGRIERTEN PHOTONISCHEN SCHALTUNG
APPAREIL INTÉGRANT UN CIRCUIT INTÉGRÉ ÉLECTRONIQUE ET UN CIRCUIT INTÉGRÉ PHOTONIQUE

(43) Date of publication of application: 30.08.2023
(73) Proprietor: Nokia Solutions and Networks Oy, 02610 Espoo (FI)
(72) Inventor: SHEN, Alexandre, 91400 Orsay (FR); ENRIGHT, Ryan, New York 11001 (US); NEEL, Delphine, 91140 Villebon-sur-Yvette (FR); BITAULD, David, 91300 Massy (FR)
(74) Representative: Novagraaf Technologies

(56) References cited:
- WO-A1-2016/122586
- US-A1- 2011 044 369
- US-A1- 2017 194 309
- BERNABÉ S ET AL: "Silicon photonics for terabit/s communication in data centers and exascale computers", SOLID STATE ELECTRONICS, ELSEVIER SCIENCE PUBLISHERS, BARKING, GB, vol. 179, 23 November 2020 (2020-11-23), XP086553005, ISSN: 0038-1101, [retrieved on 20201123], DOI: 10.1016/J.SSE.2020.107928
- YANG YAN ET AL: "Through-Si-via (TSV) Keep-Out-Zone (KOZ) in SOI Photonics Interposer: A Study of the Impact of TSV-Induced Stress on Si Ring Resonators", IEEE PHOTONICS JOURNAL, IEEE, USA, vol. 5, no. 6, 1 December 2013 (2013-12-01), pages 2700611, XP011535621, DOI: 10.1109/JPHOT.2013.2285707

## Description

### TECHNICAL FIELD

Various example embodiments relate to embodiments of an apparatus for integrating an electronic integrated circuit, hereafter abbreviated by EIC and a photonic integrated circuit, hereafter abbreviated by PIC. More particularly, various embodiments relate to enabling effective thermal management temperature control and heat removal.

### BACKGROUND

Integrated Photonics is considered to be one of the most important key technologies for a broad range of applications in many fields, such as health, environmental monitoring, telecom, datacom, transport, manufacturing, etc. Innovative products benefit from highly integrated photonic circuits comprising light sources (lasers), detectors and sensors as well as integrated electronics for driving those photonic components or processing the acquired signals. These integration efforts come together with a constant need for higher switching frequencies, especially in telecom.

One of the main obstacles to the dense and advanced integration of photonic and related electronic components into a single photonic integrated circuit (PIC) is the parasitic and detrimental thermal crosstalk effects between the integrated devices.

It is known by those skilled in the art, to realize thermal management of EIC-INTEGRATED PICs by means of a smart micro-thermoelectric coolers (pTECs) integrated circuit (TEIC) layer, sitting above a functional layer containing advanced electronic integrated circuits (EICs), allowing smaller footprint PIC and lower energy consumption.

Thus, considering the foregoing, there is growing interest in a smart thermal management solution consisting in a new approach. Documents US2011/044369, Bernabé et al "Silicon photonics for terabit/s communication in data centers and exascale computers" and WO 2016/122586 give examples of photonic assemblies.

### SUMMARY

Various embodiments provide apparatuses to remedy some or all the disadvantages of the above identified prior art.

The embodiments and features described in this specification which, if any, would fall outside the scope of the claims are to be interpreted as useful examples for understanding the various embodiments.

The claimed invention provides an apparatus integrating an Electronic Integrated Circuit (EIC) and at least one photonic-integrated circuit (PIC), said apparatus further comprising:
- a first substrate made of glass,
- an electrical interconnection plane positioned on the upper side of said first substrate, for enabling electrical interconnection of the at least one PIC and the EIC with each other;
- at least one heat generating component from the at least one photonic-integrated circuit, said at least one photonic-integrated circuit being situated on top of a silicon-on-insulator (SOI) layer and being coupled to optical inputs/outputs on top of said silicon-on-insulator (SOI) layer;
- (SOI) layer metal vias (consisting of in Through-Substrate-Vias hereinafter designated by TSV) traversing the silicon-on-insulator (SOI) layer electrically connecting the at least one heat generating component of the photonic-integrated circuit to the electrical interconnection plane;
- a lid comprising a top wall forming a thermal plane for heatsink attachment and a side wall being in contact with the silicon-on-insulator (SOI) layer, said top wall comprising an upper surface and a lower surface, said lid defining a lidded cavity comprised between the top wall the side wall and the SOI layer, wherein said lid is positioned on the silicon-on-insulator (SOI) layer such that the optical inputs/outputs of the at least one photonic integrated circuit and electrical inputs/outputs of the electrical interconnection plane are outside the lidded cavity and said at least one heat generating component from the at least one photonic-integrated circuit is encapsulated within the lidded cavity.

This apparatus allows the design and implementation of a common technology platform for various photonic integrated circuits (PICs) for various application areas such as fibre optic environmental sensing and very high-speed transceivers for the telecommunications and data communications industries, using either the coherent format or other wavelength division multiplexing systems (also called WDM systems).

Advantageously, the apparatus may further comprise an array of heat-dissipating fins (64) situated on the top side of the top wall of the lid.

Advantageously, the lid and, if applicable, the heat-dissipating fins may be made of a thermally conductive material, preferably consisting of a metal or silicon.

Advantageously, the Electronic Integrated circuit may further comprise at least one heat generating component that is an electric or electronic component from the Electronic Integrated Circuit (EIC), that is either positioned on the top side of the first substrate (i.e. the glass substrate) or on the bottom side of the first substrate.

The at least one heat generating component from the photonic-integrated circuit may be selected among usual III-V-based devices (such as laser active sections, SOAs, photodiodes or phase modulators) and Si-based devices (phase modulators, ring-resonators, Ge-based PDs).

Advantageously, the at least one heat generating component from the photonic-integrated circuit may comprise a III-V-based device.

The apparatus may further comprise:
- a micro-thermoelectric module (µTEM) for temperature controlling said at least one heat generating component from the photonic-integrated circuit, said micro-thermoelectric module (µTEM) being positioned on the surface of said photonic integrated circuit which is opposite to the silicon-on-insulator (SOI) layer,
- a first thermal interface (TIM) being both in contact with the surface of said micro-thermoelectric module (µTEM) which is opposite to said photonic integrated circuit and with the bottom side of the top wall of said lid, and
- a second thermal interface (TIM) being positioned between said micro-thermoelectric module (µTEM) and said photonic integrated circuit.

Advantageously, according to a first specific embodiment of the claimed invention, said at least one photonic integrated circuit may comprise:
- a III-V laser layer further being electrically connected via the metal vias traversing the silicon-on-insulator (SOI) layer, and
- a second heat generating component, being electrically connected to the Electronic Integrated Circuit (EIC) and to the electrical interconnection plane by means of metal vias traversing the silicon-on-insulator (SOI) layer.

The at least electrical interconnection plane may be a RF and/or DC inputs/outputs plane positioned on the upper side of said first substrate and/or said second electrical interconnection plane may be a RF and/or DC inputs/outputs plane.

Advantageously, the apparatus may further comprise an organic substrate being positioned beneath the first substrate.

Advantageously, according to a second specific embodiment of the claimed invention, the Electronic Integrated circuit may further comprise at least one heat generating component being an electric or electronic component from the Electronic Integrated Circuit (EIC)being positioned on the bottom side of the first substrate and electrically connected to said electrical interconnection plane by means of Through-Glass-Vias traversing the first substrate.

### BRIEF DESCRIPTION OF THE DRAWINGS

Some example embodiments are now described, by way of example only, and with reference to the accompanying drawings in which:
- FIG. 1 is a sectional view of a first embodiment of the apparatus;
- FIG. 2 is a detailed sectional view of the first embodiment of the apparatus shown in FIG. 1;
- FIG. 3 is a sectional view of a second embodiment of the apparatus;
- FIG. 4 is a detailed sectional view of the second embodiment of the apparatus shown in FIG. 3;
- FIG. 5 is a sectional view of a third embodiment of the apparatus;
- FIG. 6 is a detailed sectional view of the third embodiment of the apparatus shown in FIG. 5.

The same reference number represents the same element or the same type of element on all drawings, unless stated otherwise.

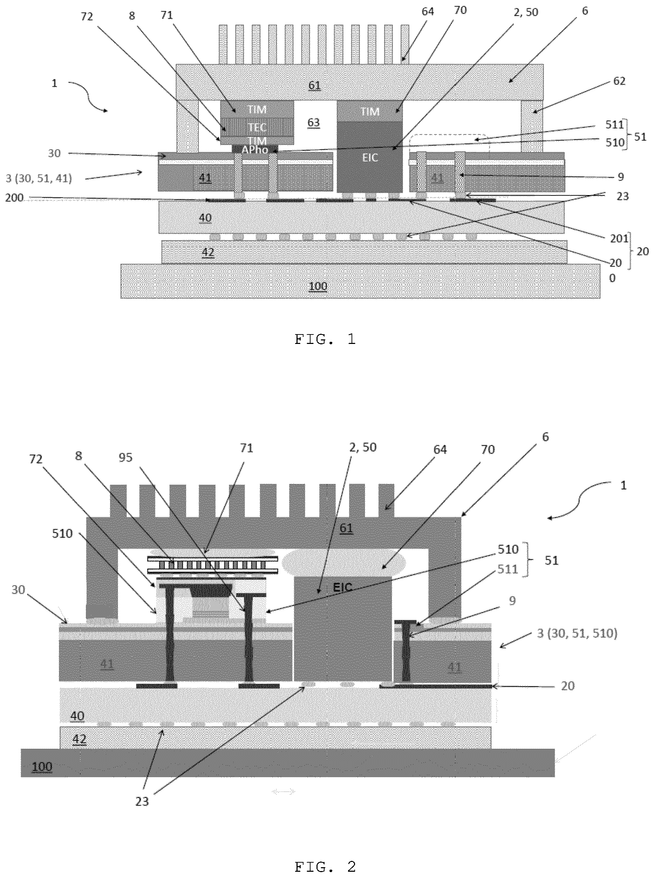

Figures 1 to 6 are described in more detail in the description which follows, given by way of indication.
figures 1 to 6 illustrate various example embodiments of the apparatus, but without limiting the scope thereof.

### DETAILLED DESCRIPTION

Various example embodiments will now be described more fully with reference to the accompanying drawings in which some example embodiments are illustrated. In the figures, the thicknesses of lines, layers or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the forms disclosed, but on the contrary, example embodiments are to cover all modifications, equivalents, and alternatives falling within the scope of the invention as defined by the appended claims.

Like numbers refer to like or similar elements throughout the description of the figures.

In the following description of the figures, schematic representations are non-limiting and serve only for the understanding.

FIGS. 1 to 6 show several variant basic architectures of an apparatus integrating an electronic integrated circuit and at least one photonic integrated circuit.

In particular, FIGs. 1 and 2 schematically represent two views of the apparatus according 1 to a first specific embodiment in which:
- a first substrate 40 comprises a glass platform (the thickness of which being comprised between 300 µm and 700 µm),
- an electrical interconnection plane 20 positioned on the upper side of the glass platform 40 and comprising metal pads and electrical lines for RF and/or DC signals transmission, for enabling electrical interconnection of the PIC and EIC devices with each other and with Inputs/outputs of the apparatus,
- a SOI layer 41 (the thickness of which being comprised between 200 µm and 700 pm) on which are bonded a heat generating component 510 from the photonic-integrated circuit 3, which may comprise a III-V-based die 510 (the height of which being comprised between 3 µm and 5 pm), a Si-based modulator 511 and optical inputs/outputs 30,
- an electric or electronic component 50 (the height of which being comprised between 150 µm and 700 pm) from the Electronic Integrated Circuit (EIC) positioned on the top side of glass platform 40,
- a lid 6 as the capping cover of the apparatus comprising a top wall 61 and a side wall 62 being in contact with the silicon-on-insulator (SOI) layer 41, and an array of heat-dissipating fins 64 on the top side of the top wall 61 of the lid 6.

The III-V-based die 510 from the PIC 3 and electric or electronic component 50 from the EIC are flip-chip bonded on the glass platform 40 through the pads (also called flip-chip balls) contacting the electrical interconnection plane 20.

It is to be remarked that also other types of PICs can be part of such apparatus, e.g. PICs for transceiver applications, containing many types of photonic devices, including lasers (DFB, extended cavity tunable lasers, frequency combs etc.), optical amplifiers (SOAs), modulators (electro-absorption modulators, Mach-Zehnder modulators, ring-resonator modulators, etc.), photodetectors (any type of photodiodes), on top of passive devices (single mode waveguides, wave couplers, multimode interferometer couplers (MMIs), mode transition tapers, Bragg grating couplers or edge couplers for optical in/outs, etc.); PICs for quantum applications, containing many of the above mentioned photonic devices, plus high finesse optical filters, variable optical attenuators, cascaded ring resonators, etc.; PICs for optical switching and routing, containing many of the above-mentioned photonic devices, plus optical switches, passive waveguide crossings, etc. The above-mentioned PIC types are not exhaustive.

The lid 6 defines a lidded cavity 63 comprised between the top wall 61, the side wall 62 and the SOI layer 41, such that the III-V-based die 510, the Si-based optical modulator and the EIC are inside this cavity, and the optical inputs/outputs 30 and the electrical inputs/outputs of the apparatus on the electrical interconnection plane 20 are outside the lidded cavity 63,

The lid 6 and the heat-dissipating fins 64 are preferably made of a thermally conductive material, such as a metal or silicon.

Metal vias 9 consisting of Through-Substrate-Vias hereinafter designated by TSV, traverse the silicon-on-insulator (SOI) layer 41 for electrically connecting the III-V-based device 510 and the Si-based optical modulator 511 to the EIC 2 via the electrical interconnection plane 20.

Furthermore, the III-V laser die 510 is also electrically connected via such TSV metal vias. Fig. 2 depicts more in detail how secondary vias 95 traversing said III-V laser die 510 may be further needed to this end.

In addition an organic substrate 42 is present on the bottom surface of the glass platform 40, to which it is attached by means of regularly spaced bumps or an underfill.

As one can observe from Figs 1 and 2, the apparatus according 1 to the first specific embodiment further comprises:
- a micro-thermoelectric module (µTEM) 8 (the height of which being comprised between 10 µm to 100 pm) e.g. consisting of a thermoelectric cooler TEC for temperature controlling the III-V laser die 510, this TEC 8 being flip-chip bonded on the surface of the laser III-V laser die 510,
- a first thermal interface (TIM) 71 being both in contact with the surface of the TEC 8 and with the bottom side of the top wall 61 of the lid 6, and
- a second thermal interface (TIM) 72 being positioned between the TEC 8 and the III-V laser die 510.

As earlier mentioned, secondary vias 95 traversing said III-V laser die 510 are present for electrically connecting the III-V laser die to the TGV metal vias 9.

A thermal conductive, yet electrical insulating thin layer (such as AlN) 72 may be positioned between this thermal management layer 8 (TEC) and the functional layer.

In some embodiments, the TEC may be needed to be electrically driven, via further electrical contacts and interconnections between the TEC 8 and the electrical interconnection layer on the upper surface of the glass platform 40.

As to the electric or electronic component 50 from the EIC 2, the apparatus according 1 to this first specific embodiment further comprises a third thermal interface (TIM) 70 being positioned between the bottom side of the top wall 61 of the lid 6 and the electric or electronic component 50.

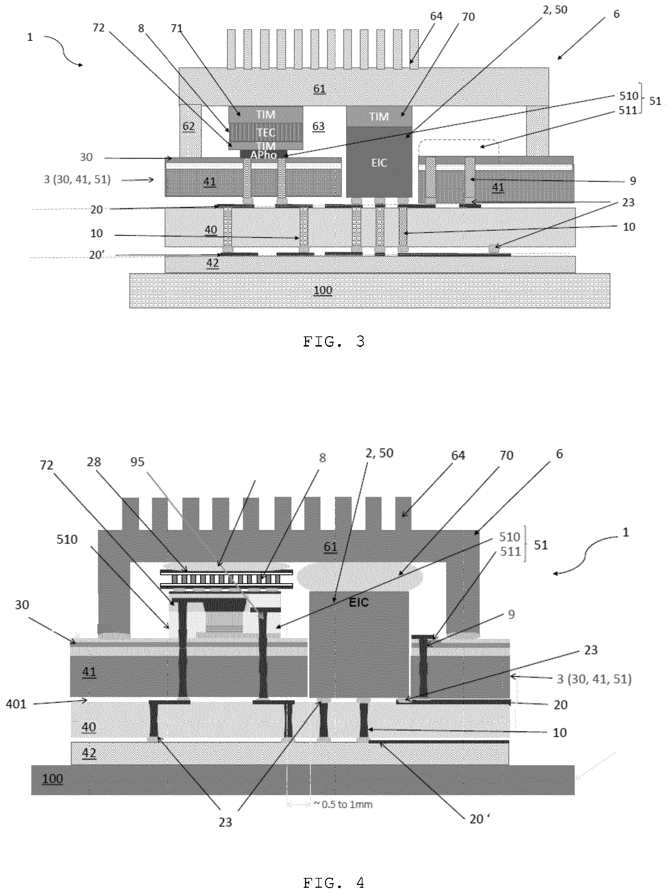

Figures 3 and 4 schematically represent two views of the apparatus according to a second specific embodiment that differs from the first one (shown in FIGs. 1 and 2) in that it further comprises a second electrical interconnection plane 20', in this embodiment used for providing the DC inputs/outputs, while the first interconnection plane is merely serving to guide the RF electrical input/output signals. The second interconnection plane 20' is positioned on the bottom side of said first substrate 40 and electrically connected to the first interconnection plane for providing DC signals to the components by means of Through-Glass-Vias 10 traversing the glass platform 40.

The TGVs 10 may be drilled in the glass substrate 40. Since ordinary glass is used, cylindrical holes 10 can be drilled and filled with metal in order to provide DC signals to circuits from the second interconnection plane 20' on the rear (down) side of the glass platform 40.

This variant has the advantage of doubling the surface for electrical routing, which can help the decrease the overall footprint of the integrated circuits system. Indeed, due to larger (and increasing) number of devices in PICs and EICs, electrical routing fan-out and the global size of the integrated system is bounded by the peripheral electrical I/O pad distribution. Providing this pad distribution on two levels (at both sides of the glass platform) instead of only one level (only the upper surface as in the previous embodiment) does have the advantage of decreasing the global horizontal footprint of the whole system. For practical and obvious reasons, it is better to use the upper surface for RF routing and I/O pads 20 since this reduces the RF line length.

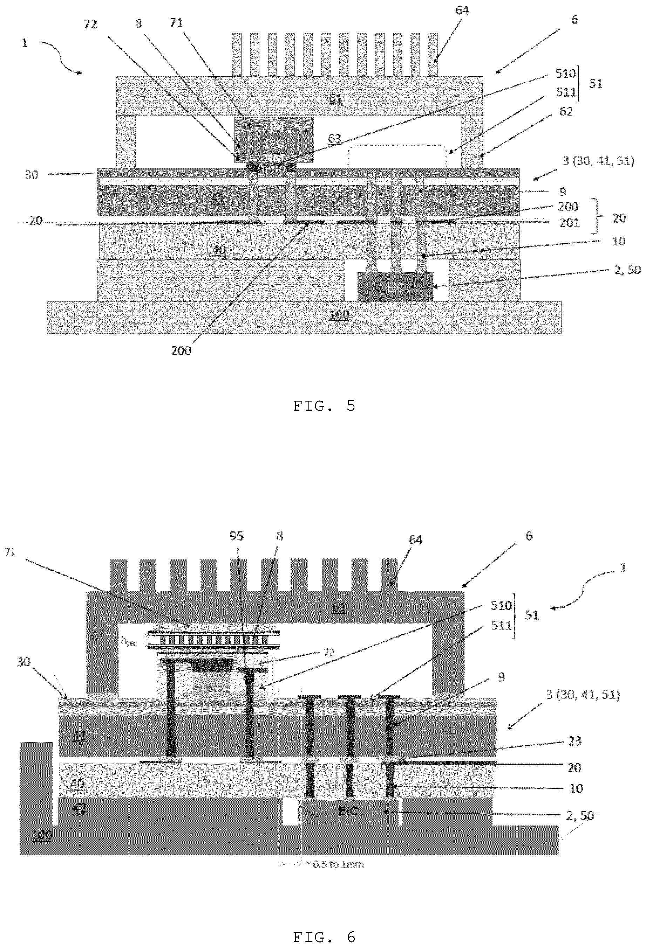

Figures 5 and 6 schematically represent two views of the apparatus according to a third specific embodiment that differs from the first one (shown in FIGs. 1 and 2) in that an electric or electronic component 50 from the Electronic Integrated Circuit (EIC) is positioned on the bottom side of glass platform 40 (the thickness of which is comprised between 200 and 700 pm) and electrically connected to the electrical interconnection plane 20 by means of Through-Glass-Vias 10 traversing glass platform 40.

In that configuration, the interconnection layer is a RF and DC inputs/outputs plane that is set on the upper side of the glass platform 40 to benefit from the low RF propagation loss. This configuration can present other advantages as the heat generating EICs 50 are further away from the temperature sensitive devices on the PIC 3, the heat insulation is better in this third embodiment, than in the first and second embodiments. In this third embodiment, the SOI thickness is comprised between 150 µm and 750 µm.

In some further variants of all these three specific embodiments, the upper surface of the PIC 3 can further be used for DC line routing and can provide DC pads at its peripheral sides, thus providing in this way an additional electrical interconnection layer, further contributing in reducing the overall size of the integrated system. This feature is not represented in any of figures 1 to 6.

## Claims

1. An apparatus (1) integrating an Electronic Integrated Circuit, EIC, (2) and at least one photonic-integrated circuit, PIC (51), said apparatus (1) further comprising:
• a first substrate (40) made of glass;
• an electrical interconnection plane (20) positioned on the upper side of said first substrate (40), for enabling electrical interconnection of the at least one PIC and the EIC with each other;
• at least one heat generating component (510, 511) from the at least one photonic-integrated circuit (51), said at least one photonic-integrated circuit (51) being situated on top of a silicon-on-insulator SOI, layer (41), said photonic integrated circuit (51) being coupled to optical inputs/outputs (30) on top of said silicon-on-insulator, SOI, layer (41);
• metal vias (9) traversing the silicon-on-insulator, SOI, layer (41) electrically connecting the at least one heat generating component (510, 511) of the photonic-integrated circuit (51) to the electrical interconnection plane (20);
the apparatus being **characterized in** further comprising - a lid (6) comprising a top wall (61) and a side wall (62) being in contact with the silicon-on-insulator, SOI, layer (41), said top wall (61) comprising an upper surface and a lower surface, said lid (6) defining a lidded cavity (63) comprised between the top wall (61), the side wall (62) and the SOI layer wherein said lid (6) is positioned on the silicon-on-insulator, SOI, layer (41) such that the optical inputs/outputs (30) of the at least one photonic integrated circuit (51) and electrical inputs/outputs of the electrical interconnection plane (20) are outside the lidded cavity (63), and said at least one heat generating component (510, 511) from the at least one photonic-integrated circuit (51) is encapsulated within the lidded cavity (63).

2. The apparatus (1) according to claim 1, further comprising an array of heat-dissipating fins (64) situated on the top side of the top wall (61) of said lid (6).

3. The apparatus (1) according to claim 2, wherein said lid (6) and said heat-dissipating fins (64) are made of a thermally conductive material.

4. The apparatus (1) according to any of claims 1 to 3, wherein the Electronic Integrated circuit further comprises at least one heat generating component (5) being an electric or electronic component (50) from the Electronic Integrated Circuit, EIC, said electric or electronic component (50) being positioned on the top side of said first substrate (40) or on the bottom side of said first substrate (40).

5. The apparatus (1) according to any of claims 1 to 4, wherein said at least one heat generating component (510, 511) from the at least one photonic-integrated circuit (51) comprises a III-V-based device (510).

6. The apparatus (1) according to any of claims 1 to 5, further comprising
• a micro-thermoelectric module, µTEM, (8) for temperature controlling said at least one heat generating component (510, 511) from the at least one photonic-integrated circuit (51), said micro-thermoelectric module, µTEM, (8) being positioned on the surface of said at least one photonic integrated circuit (51) which is opposite to the silicon-on-insulator, SOI, layer (41),
• a first thermal interface, TIM, (71) being both in contact with the surface of said micro-thermoelectric module, µTEM, (8) which is opposite to said at least one photonic integrated circuit (51) and with the bottom side of the top wall (61) of said lid (6), and
• a second thermal interface, TIM, (72) being positioned between said micro-thermoelectric module, µTEM, (8) and said at least one photonic integrated circuit (51)

7. The apparatus (1) according to any of claims 1 to 6, wherein:
• said at least one photonic integrated circuit (51) comprises a III-V laser layer further being electrically connected via the metal vias (9) traversing the silicon-on-insulator, SOI, layer (41),
• said at least one photonic-integrated circuit (51) further comprises a second heat generating component (511), being electrically connected to the Electronic Integrated Circuit, EIC, (2) and to the electrical interconnection plane (20) by means of metal vias (9) traversing the silicon-on-insulator, SOI, layer (41).

8. The apparatus (1) according to claim 7, wherein said second heat generating component comprises a Si-based phase modulator (511).

9. The apparatus (1) according to any of claims 1 to 8 when it depends on claim 4, wherein
• said electric or electronic component (50) from the Electronic Integrated Circuit, EIC, (2) is positioned on the top side of said first substrate (40);
• said apparatus (1) further comprises a third thermal interface, TIM, (70) being positioned between the bottom side of the top wall (61) of said lid (6) and said electric or electronic component (50).

10. The apparatus (1) according to any of claims 1 to 9, wherein said apparatus (1) further comprises a second electrical interconnection plane (20') said second electrical interconnection plane (20') being positioned on the bottom side of said first substrate (40) and electrically connectable to said at least one photonic integrated circuit and/or said electrical integrated circuit by means of Through-Glass-Vias (10) traversing the first substrate (40).

11. The apparatus (1) according to any of claims 1 to 10, wherein said electrical interconnection plane (20) is a RF and/or DC inputs/outputs plane positioned on the upper side of said first substrate (40) and/or wherein said second electrical interconnection plane (20') is a RF and/or DC inputs/outputs plane.

12. The apparatus (1) according to claim 1 or 2, wherein the Electronic Integrated circuit further comprises at least one heat generating component (5) being an electric or electronic component (50) from the Electronic Integrated Circuit, EIC, being positioned on the bottom side of said first substrate (40) and electrically connected to said electrical interconnection plane (20) by means of Through-Glass-Vias (10) traversing the first substrate (40).

13. The apparatus (1) according to any of claims 1 to 11, further comprising an organic substrate (42) being positioned beneath said first substrate.

## Patentansprüche

1. Einrichtung (1) zum Integrieren einer elektronischen integrierten Schaltung, EIC, (2) und mindestens einer photonischen integrierten Schaltung, PIC (51), wobei die Einrichtung (1) ferner Folgendes umfasst:
• ein erstes Substrat (40) aus Glas;
• eine elektrische Verbindungsebene (20), die auf der Oberseite des ersten Substrats (40) positioniert ist, zum Ermöglichen einer elektrischen Verbindung der mindestens einen PIC und der EIC miteinander;
• mindestens eine wärmeerzeugende Komponente (510, 511) der mindestens einen photonischen integrierten Schaltung (51), wobei sich die mindestens eine photonische integrierte Schaltung (51) auf einer Silizium-auf-Isolator(SOI)-Schicht (41) befindet, wobei die photonische integrierte Schaltung (51) an optische Eingänge/Ausgänge (30) auf der Silizium-auf-Isolator(SOI)-Schicht (41) gekoppelt ist;
• Metalldurchkontaktierungen (9), die die Silizium-auf-Isolator(SOI)-Schicht (41) durchqueren und die mindestens eine wärmeerzeugende Komponente (510, 511) der photonischen integrierten Schaltung (51) mit der elektrischen Verbindungsebene (20) elektrisch verbinden;
wobei die Einrichtung **dadurch gekennzeichnet ist, dass** sie ferner einen Deckel (6) umfasst, der eine obere Wand (61) und eine Seitenwand (62) umfasst, die mit der Silizium-auf-Isolator(SOI)-Schicht (41) in Kontakt sind, wobei die obere Wand (61) eine obere Fläche und eine untere Fläche umfasst, wobei der Deckel (6) einen abgedeckten Hohlraum (63) definiert, der zwischen der oberen Wand (61), der Seitenwand (62) und der SOI-Schicht umfasst ist, wobei der Deckel (6) auf der Silizium-auf-Isolator(SOI)-Schicht (41) positioniert ist, derart, dass die optischen Eingänge/Ausgänge (30) der mindestens einen photonischen integrierten Schaltung (51) und die elektrischen Eingänge/Ausgänge der elektrischen Verbindungsebene (20) sich außerhalb des abgedeckten Hohlraums (63) befinden, und die mindestens eine wärmeerzeugende Komponente (510, 511) der mindestens einen photonischen integrierten Schaltung (51) im abgedeckten Hohlraum (63) gekapselt ist.

2. Einrichtung (1) nach Anspruch 1, die ferner ein Array von wärmeableitenden Rippen (64) umfasst, die sich auf der oberen Seite der oberen Wand (61) des Deckels (6) befinden.

3. Einrichtung (1) nach Anspruch 2, wobei der Deckel (6) und die wärmeableitenden Rippen (64) aus einem thermisch leitfähigen Material bestehen.

4. Einrichtung (1) nach einem der Ansprüche 1 bis 3, wobei die elektronische integrierte Schaltung ferner mindestens eine wärmeerzeugende Komponente (5) umfasst, bei der es sich um eine elektrische oder elektronische Komponente (50) der elektronischen integrierten Schaltung, EIC, handelt, wobei die elektrische oder elektronische Komponente (50) auf der oberen Seite des ersten Substrats (40) oder auf der unteren Seite des ersten Substrats (40) positioniert ist.

5. Einrichtung (1) nach einem der Ansprüche 1 bis 4, wobei die mindestens eine wärmeerzeugende Komponente (510, 511) der mindestens einen photonischen integrierten Schaltung (51) eine III-V-basierte Vorrichtung (510) umfasst.

6. Einrichtung (1) nach einem der Ansprüche 1 bis 5, die ferner Folgendes umfasst
• ein thermoelektrisches Mikromodul, µTEM, (8) zur Temperatursteuerung der mindestens einen wärmeerzeugenden Komponente (510, 511) der mindestens einen photonischen integrierten Schaltung (51), wobei das thermoelektrische Mikromodul, µTEM, (8) auf der Fläche der mindestens einen photonischen integrierten Schaltung (51) positioniert ist, die sich gegenüber der Silizium-auf-Isolator(SOI)-Schicht (41) befindet,
• eine erste thermische Schnittstelle, TIM, (71), die sowohl mit der Fläche des thermoelektrischen Mikromoduls, µTEM, (8), das sich gegenüber der mindestens einen photonischen integrierten Schaltung (51) befindet, als auch mit der unteren Seite der oberen Wand (61) des Deckels (6) in Kontakt ist, und
• eine zweite thermische Schnittstelle, TIM, (72), die zwischen dem thermoelektrischen Mikromodul, µTEM, (8) und der mindestens einen photonischen integrierten Schaltung (51) positioniert ist

7. Einrichtung (1) nach einem der Ansprüche 1 bis 6, wobei:
• die mindestens eine photonische integrierte Schaltung (51) eine III-V-Laserschicht umfasst, die via die Metalldurchkontaktierungen (9), die die Silizium-auf-Isolator(SOI)-Schicht (41) durchqueren, elektrisch verbunden ist,
• die mindestens eine photonische integrierte Schaltung (51) ferner eine zweite wärmeerzeugende Komponente (511) umfasst, die mittels der Metalldurchkontaktierungen (9), die die Silizium-auf-Isolator(SOI)-Schicht (41) durchqueren, mit der elektronischen integrierten Schaltung, EIC, (2) und der elektrischen Verbindungsebene (20) elektrisch verbunden ist.

8. Einrichtung (1) nach Anspruch 7, wobei die zweite wärmeerzeugende Komponente einen Si-basierten Phasenmodulator (511) umfasst.

9. Einrichtung (1) nach einem der Ansprüche 1 bis 8, sofern von Anspruch 4 abhängig, wobei
• die elektrische oder elektronische Komponente (50) der elektronischen integrierten Schaltung, EIC, (2) auf der oberen Seite des ersten Substrats (40) positioniert ist;
• die Einrichtung (1) ferner eine dritte thermische Schnittstelle, TIM, (70) umfasst, die zwischen der unteren Seite der oberen Wand (61) des Deckels (6) und der elektrischen oder elektronischen Komponente (50) positioniert ist.

10. Einrichtung (1) nach einem der Ansprüche 1 bis 9, wobei die Einrichtung (1) ferner eine zweite elektrische Verbindungsebene (20`) umfasst, wobei die zweite elektrische Verbindungsebene (20`) auf der unteren Seite des ersten Substrats (40) positioniert und mit der mindestens einen photonischen integrierten Schaltung und/oder der elektrischen integrierten Schaltung mittels Durch-Glas-Durchkontaktierungen (10), die das erste Substrat (40) durchqueren, elektrisch verbindbar ist.

11. Einrichtung (1) nach einem der Ansprüche 1 bis 10, wobei die elektrische Verbindungsebene (20) eine Ebene für RF- und/oder für DC-Eingänge/Ausgänge ist, die auf der oberen Seite des ersten Substrats (40) positioniert ist, und/oder wobei die zweite elektrische Verbindungsebene (20') eine Ebene für RF- und/oder DC-Eingänge/Ausgänge ist.

12. Einrichtung (1) nach Anspruch 1 oder 2, wobei die elektronische integrierte Schaltung ferner mindestens eine wärmeerzeugende Komponente (5) umfasst, bei der es sich um eine elektrische oder elektronische Komponente (50) der elektronischen integrierten Schaltung, EIC, handelt, die auf der unteren Seite des ersten Substrats (40) positioniert und mit der elektrischen Verbindungsebene (20) mittels Durch-Glas-Durchkontaktierungen (10), die das erste Substrat (40) durchqueren, elektrisch verbunden ist.

13. Einrichtung (1) nach einem der Ansprüche 1 bis 11, die ferner ein organisches Substrat (42) umfasst, das unter dem ersten Substrat positioniert ist.

## Revendications

1. Appareil (1) intégrant un circuit intégré électronique, EIC, (2) et au moins un circuit intégré photonique, PIC, (51), ledit appareil (1) comprenant en outre :
• un premier substrat (40) réalisé en verre ;
• un plan d'interconnexion électrique (20) positionné sur le côté supérieur dudit premier substrat (40) pour permettre l'interconnexion électrique de l'au moins un PIC et de l'EIC l'un avec l'autre ;
• au moins un composant de génération de chaleur (510, 511) provenant de l'au moins un circuit intégré photonique (51), ledit au moins un circuit intégré photonique (51) étant situé sur le haut d'une couche de silicium sur isolant, SOI, (41), ledit circuit intégré photonique (51) étant couplé à des entrées/sorties optiques (30) sur le haut de ladite couche de silicium sur isolant, SOI, (41) ;
• des trous de liaison métalliques (9) traversant la couche de silicium sur isolant, SOI, (41) et connectant électriquement l'au moins un composant de génération de chaleur (510, 511) du circuit intégré photonique (51) au plan d'interconnexion électrique (20) ;
l'appareil étant **caractérisé en ce qu'**il comprend en outre un couvercle (6) comprenant une paroi en haut (61) et une paroi latérale (62) en contact avec la couche de silicium sur isolant, SOI, (41), ladite paroi en haut (61) comprenant une surface supérieure et une surface inférieure, ledit couvercle (6) définissant une cavité à couvercle (63) comprise entre la paroi en haut (61), la paroi latérale (62) et la couche SOI, dans lequel ledit couvercle (6) est positionné sur la couche de silicium sur isolant, SOI, (41) de sorte que les entrées/sorties optiques (30) de l'au moins un circuit intégré photonique (51) et que les entrées/sorties électriques du plan d'interconnexion électrique (20) se trouvent à l'extérieur de la cavité à couvercle (63), et ledit au moins un composant de génération de chaleur (510, 511) provenant de l'au moins un circuit intégré photonique (51) est encapsulé à l'intérieur de la cavité à couvercle (63).

2. Appareil (1) selon la revendication 1, comprenant en outre un réseau d'ailettes de dissipation thermique (64) situées sur le côté du haut de la paroi en haut (61) dudit couvercle (6) .

3. Appareil (1) selon la revendication 2, dans lequel ledit couvercle (6) et lesdites ailettes de dissipation thermique (64) sont réalisés en un matériau thermoconducteur.

4. Appareil (1) selon l'une des revendications 1 à 3, dans lequel le circuit intégré électronique comprend en outre au moins un composant de génération de chaleur (5) qui est un composant électrique ou électronique (50) provenant du circuit intégré électronique, EIC, ledit composant électrique ou électronique (50) étant positionné sur le côté du haut dudit premier substrat (40) ou sur le côté du bas dudit premier substrat (40).

5. Appareil (1) selon l'une des revendications 1 à 4, dans lequel ledit au moins un composant de génération de chaleur (510, 511) provenant de l'au moins un circuit intégré photonique (51) comprend un dispositif à base de III-V (510).

6. Appareil (1) selon l'une des revendications 1 à 5, comprenant en outre
• un module micro-thermoélectrique, µTEM, (8) pour réguler la température dudit au moins un composant de génération de chaleur (510, 511) provenant de l'au moins un circuit intégré photonique (51), ledit module micro-thermoélectrique, µTEM, (8) étant positionné sur la surface dudit au moins un circuit intégré photonique (51) qui est opposée à la couche de silicium sur isolant, SOI, (41),
• une première interface thermique, TIM, (71) à la fois en contact avec la surface dudit module micro-thermoélectrique, µTEM, (8) qui est opposée audit au moins un circuit intégré photonique (51) et avec le côté du bas de la paroi en haut (61) dudit couvercle (6), et
• une deuxième interface thermique, TIM, (72) positionnée entre ledit module micro-thermoélectrique, µTEM, (8) et ledit au moins un circuit intégré photonique (51).

7. Appareil (1) selon l'une des revendications 1 à 6, dans lequel :
• ledit au moins un circuit intégré photonique (51) comprend une couche laser III-V qui est en outre connectée électriquement par les trous de liaison métalliques (9) traversant la couche de silicium sur isolant, SOI, (41),
• ledit au moins un circuit intégré photonique (51) comprend en outre un deuxième composant de génération de chaleur (511) connecté électriquement au circuit intégré électronique, EIC, (2) et au plan d'interconnexion électrique (20) au moyen des trous de liaison métalliques (9) traversant la couche de silicium sur isolant, SOI, (41).

8. Appareil (1) selon la revendication 7, dans lequel ledit deuxième composant de génération de chaleur comprend un modulateur de phase à base de Si (511).

9. Appareil (1) selon l'une des revendications 1 à 8 lorsqu'elles dépendent de la revendication 4, dans lequel
• ledit composant électrique ou électronique (50) provenant du circuit intégré électronique, EIC, (2) est positionné sur le côté du haut dudit premier substrat (40) ;
• ledit appareil (1) comprend en outre une troisième interface thermique, TIM, (70) qui est positionnée entre le côté du bas de la paroi en haut (61) dudit couvercle (6) et ledit composant électrique ou électronique (50).

10. Appareil (1) selon l'une des revendications 1 à 9, dans lequel ledit appareil (1) comprend en outre un deuxième plan d'interconnexion électrique (20'), ledit deuxième plan d'interconnexion électrique (20') étant positionné sur le côté du bas dudit premier substrat (40) et pouvant être connecté électriquement audit au moins un circuit intégré photonique et/ou audit circuit intégré électrique au moyen de trous de liaison dans le verre (10) traversant le premier substrat (40).

11. Appareil (1) selon l'une des revendications 1 à 10, dans lequel ledit plan d'interconnexion électrique (20) est un plan d'entrées/sorties RF et/ou DC positionné sur le côté supérieur dudit premier substrat (40), et/ou dans lequel ledit deuxième plan d'interconnexion électrique (20') est un plan d'entrées/sorties RF et/ou DC.

12. Appareil (1) selon la revendication 1 ou 2, dans lequel le circuit intégré électronique comprend en outre au moins un composant de génération de chaleur (5) qui est un composant électrique ou électronique (50) provenant du circuit intégré électronique, EIC, positionné sur le côté du bas dudit premier substrat (40) et connecté électriquement audit plan d'interconnexion électrique (20) au moyen des trous de liaison dans le verre (10) traversant le premier substrat (40).

13. Appareil (1) selon l'une des revendications 1 à 11, comprenant en outre un substrat organique (42) positionné sous ledit premier substrat.
